# EUROPEAN PATENT SPECIFICATION

(11) **EP 2 199 752 B1**
(45) Date of publication and mention of the grant of the patent: **28.08.2019**
(21) Application number: 08382078.7
(22) Date of filing: 17.12.2008
(51) Int. Cl.: G01D 5/245, G01D 5/249, H03M 1/28, H03M 1/14, H03M 1/30

(54) **Absolute position encoder**
Absolutpositionsgeber
Codeur de position absolue

(43) Date of publication of application: 23.06.2010
(73) Proprietor: FAGOR, S.COOP., 20500 Mondragon (Gipuzkoa) (ES)
(72) Inventor: Morlanes Calvo, Tomás, 01011, Vitoria-Gasteiz (ES); de la Fuente Prado, Pablo, 48004, Bilbao (ES)
(74) Representative: Igartua, Ismael

(56) References cited:
- WO-A2-2004/005855
- GB-A- 2 185 359
- US-A1- 2003 145 479
- US-A1- 2004 174 161

## Description

### TECHNICAL FIELD

The invention relates to encoders adapted to measure the position of a moving element in relation to a stationary element, and more specifically to encoders adapted to measure the absolute position of the moving element in relation to the stationary element.

### PRIOR ART

Encoders adapted to determine the relative position between a first element and a second element that may be displaced in relation to each other are known. Generally, one element is a scale graduation element that remains stationary while the other element is a readhead that may be displaced in relation to the scale graduation element in a direction of displacement substantially parallel to said scale graduation element. The scale graduation element comprises an incremental track in order to be able to determine the displacement of said scale graduation element in relation to the readhead, taking as a reference the position in which said readhead is found when said encoder is switched on or when it is reset, for example. The readhead comprises at least one light emitter for lighting up the incremental track of the scale graduation element and an analyser that receives the light that passes through or is reflected on said scale graduation element, said analyser comprising some photodetector means adapted to generate electrical signals representative of the light they receive. The encoder also comprises processing means that receive the electrical signals, determining the position of the readhead in accordance with said electrical signals received. This by itself is not sufficient to ascertain the absolute position of the readhead in relation to the scale graduation element, as it only allows the displacement between both to be ascertained from the moment when the encoder is switched on or when it is reset.

In many cases it is also necessary to ascertain the absolute position of the readhead in relation to the scale graduation element. Said scale graduation element comprises a point of origin identified by default, and the absolute position relates to a position determined in relation to said point of origin. Encoders adapted to measure absolute positions are known, the scale graduation element of said encoders comprising an absolute track or at least one reference mark for the identification of said absolute position. The readhead comprises a light emitter for lighting up the absolute track or the reference mark, and the photodetector means generate at least one additional electrical signal representative of the light that is reflected on or passes through said absolute track or reference mark. The processing means determine the absolute position of the readhead in accordance with said additional electrical signal.

In some encoders, such as those disclosed in documents US 3162711, US 3187187, US 4678908 and EP 453971, the scale graduation element comprises a reference mark for determining the absolute position. The photodetector means generate two electrical signals in quadrature representative of the light that is reflected on or passes through the incremental track and at least one additional electrical signal representative of the light that is reflected on or passes through the reference mark, and the processing means determine the incremental position of the readhead in relation to the scale graduation element in accordance with said electrical signals in quadrature, taking as an origin a reference position determined from the additional electrical signal. The reference mark may be disposed on the scale graduation element or parallel to said scale graduation element, for example, and a displacement of the readhead is necessary in order to detect said reference mark and thereby determine the absolute position of the readhead.

In order to prevent this initial displacement of the readhead, instead of a reference mark some encoders use a scale graduation element that comprises an absolute track with a specific etching with a code based on a digital pseudo-random sequence (PRBS), such as the encoders disclosed in patent documents EP 1577646 A1 and ES 2199686 B1, said absolute track generally being disposed on the scale graduation element. Said encoders also comprise a linear arrangement of photodetectors for generating at least one additional electrical signal representative of the light that is reflected on or passes through the absolute track. There are different ways of implementing the code, such as a standard binary code of the type disclosed in patent document ES 2032719 A1, another of the Manchester type such as that shown in patent document GB2126444A, and another in which the lines of said code are widened and narrowed, such as the one shown in patent document DE 4436784 B4, for example.

EP 503716 B1 discloses an encoder in which a pseudo-random code is used in order to obtain the absolute position of the readhead without having to displace it. When the code is implemented certain requirements have to be fulfilled to ensure that the absolute track may carry out the function of an incremental track and an absolute track simultaneously, a restrictive pseudo-random code that depends on the incremental track being obtained as a result. In addition, the depositing of dirt on the scale graduation element and even the quality of the material used to make said scale graduation element may be harmful to the operating of the encoder at the moment of determining the absolute position of the readhead.

US 2004/174161 A1 discloses a position sensing system comprising at least one sensor which is able to move relative to a transducer sensor. A scale is provided a transducer, said scale comprising a code detectable by the sensor by which the position of the sensor relative to the scale is able to be measured. The scale can be formed by at least one absolute encoded scale, which comprises a pseudo - random code, and at least one incremental scale.

WO 2004/005855 A2 discloses an optical encoder including a sensor head and an encoder scale comprising a first track and a second track, a first beam of light being directed towards the first track and a second beam of light being directed towards the second track, and both beams being received by respective detector when diffracted by the corresponding track.

US 2003/0145479 A1 discloses a scale suitable for an absolute position determination, including a track which extends in a measuring direction. At least first, second and third graduation areas with different optical properties are arranged in the track, wherein a first logical signal is unequivocally assigned to a first combination of two successive different graduation areas, and a second logical signal is unequivocally assigned to a second combination of two successive different graduation areas, and wherein both combinations differ from each other.

GB 2185359 A discloses an optical displacement sensor comprising an optically detectable coded track, a light emitter and a light detector. The track can be coded with a pseudo - random binary sequence with the bits of the code being optically distinguishable. The light illuminates the track and the light detector receives said light after illuminating the track, so that the position along the track can be indicated thanks to said code.

### DISCLOSURE OF THE INVENTION

It is an object of the invention to provide an absolute position encoder, and, more specifically, an absolute position encoder that improves some of the features of the prior art.

The absolute position encoder of the invention comprises a scale graduation element and a readhead that may be displaced in relation to the scale graduation element in a direction of displacement. The readhead comprises at least one light emitter for lighting up the scale graduation element, and an analyser that is reached by at least part of the light that passes through or is reflected on said scale graduation element, and which is adapted to generate electrical signals representative of said received light. The scale graduation element comprises an incremental track with a plurality of marks distributed in the direction of displacement with a specific incremental period, and an absolute track with a plurality of marks distributed in said direction of displacement.

The absolute track is disposed in an arrangement parallel to the incremental track, and comprises a pseudo-random sequence of marks that are distributed pseudo-randomly in the direction of displacement, and a periodic sequence of marks that are distributed with a specific absolute period in said direction of displacement, the absolute period being greater than the incremental period and a whole multiple of said incremental period. The marks of the pseudo-random sequence are disposed between the marks of the periodic sequence, with only one mark being disposed between two marks of said periodic sequence separated from both marks of the periodic sequence, or none. The presence or absence of said marks of the pseudo-random sequence between the marks of the periodic sequence define the code with which the absolute position of the readhead is determined. The analyser generates at least one additional electrical signal representative of the light that passes through or is reflected on the absolute track, the absolute position of the readhead being determined in accordance with said additional electrical signal.

The absolute track used in the encoder of the invention enables the additional electrical signal representative of the light that passes through or is reflected on said absolute track to be comprised of a greater number of transitions, regardless of the pseudo-random code used without restrictions. As a result, if two marks in said pseudo-random sequence are disposed in two adjacent spaces delimited by marks in the periodic sequence, for example, in contrast to the prior art, there are at least two transitions in said additional electrical signal for each mark.

An encoder that is more immune to the presence of dirt on the scale graduation element or the imperfections of the material used for the manufacture of said scale graduation element can thus be obtained, thereby providing a more robust absolute position encoder. In addition, it is possible to detect the presence of sufficiently large amounts of dirt, as transitions in the electrical signal representative of the light that passes through or is reflected on the absolute track would not be seen.

These and other advantages and characteristics of the invention will be made evident in the light of the drawings and the detailed description thereof.

### DESCRIPTION OF THE DRAWINGS

Figure 1 shows an embodiment of the encoder of the invention.
Figure 2 is a view in perspective of the additional photodetector means and the emitter of the readhead of the encoder of Figure 1.
Figure 3 is a partial ground view of an embodiment of a scale graduation element of the encoder of Figure 1.
Figure 4 shows an embodiment of the absolute track disposed on the scale graduation element of Figure 3.
Figure 5 shows an additional electrical signal for the embodiment of the absolute track of Figure 4, the absolute period of the absolute track being equal to twice the incremental period of the incremental track.
Figure 6 shows an additional electrical signal for the embodiment of the absolute track of Figure 4, the absolute period of the absolute track being equal to three times the incremental period of the incremental track.
Figure 7 shows a track of the prior art, which performs the functions of an incremental track and an absolute track.
Figure 8 shows an additional electrical signal resulting from the use of a reading system according to a preferred embodiment of the encoder of the invention, for the incremental track of Figure 7.

### DETAILED DISCLOSURE OF THE INVENTION

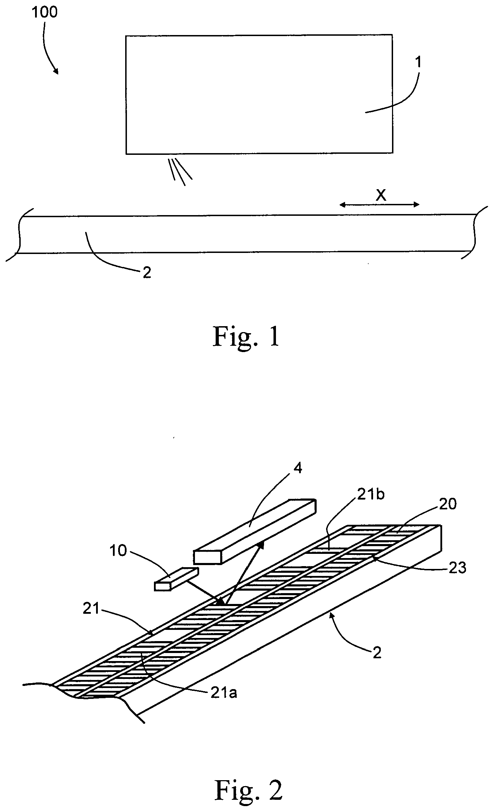

Figures 1 and 2 show an embodiment of the encoder 100 of the invention, used in order to measure the position of one element in relation to another. The encoder 100 comprises a stationary scale graduation element 2 and a readhead 1 that may be displaced in relation to the scale graduation element 2 in a direction of displacement X substantially parallel to said scale graduation element 2, the position of the readhead 1 being determined in relation to the scale graduation element 2 in the direction of displacement X.

The readhead 1 comprises at least one light emitter for lighting up the scale graduation element 2 and an analyser that receives the light that passes through or is reflected on said scale graduation element 2. The analyser generates electrical signals representative of the light received by said analyser, and the readhead 1 also comprises processing means (not shown in the figures) that receive said electrical signals and which determine the position of the readhead 1 in accordance with them. The scale graduation element 2 comprises an incremental track 23 with a plurality of periodic marks 20 distributed in the direction of displacement X with an incremental period P20, the analyser comprising photodetector means (not shown in the figures) that generate two electrical signals in quadrature representative of the light that after passing through or being reflected on the periodic marks 20 reaches the analyser, said electrical signals in quadrature being used to determine an incremental position between the readhead 1 and said scale graduation element 2. The scale graduation element 2 also comprises an absolute track 21 and the analyser also comprises additional photodetector means 4 that generate at least one additional electrical signal 5 representative of the light that after passing through or being reflected on the absolute track 21 reaches the analyser, said additional electrical signal 5 being used to determine the absolute position of the readhead 1. Said additional photodetector means 4 correspond with a linear arrangement of photodetectors. Preferably, the encoder 100 comprises a first emitter for lighting up the incremental track 23, and a second emitter 10 for lighting up the absolute track 21.

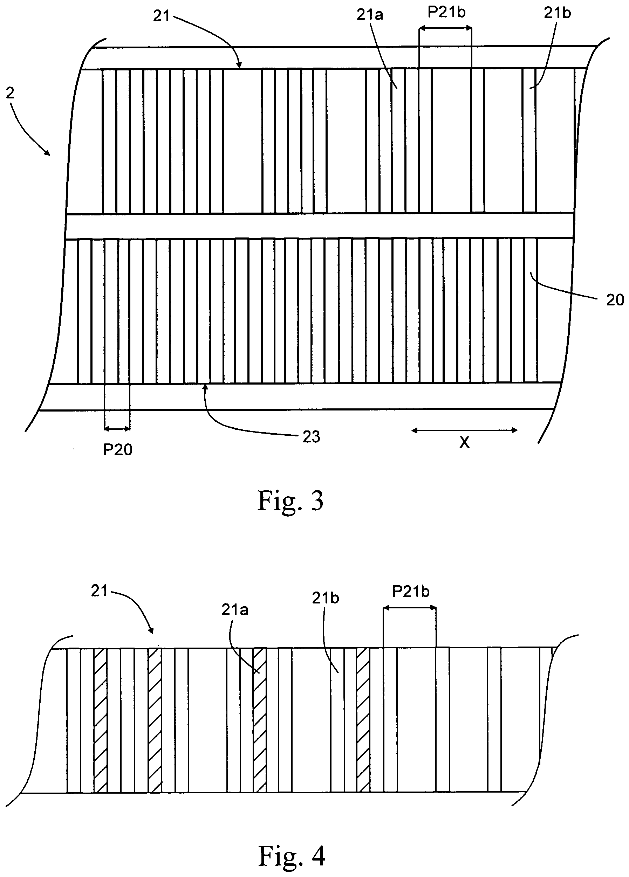

The absolute track 21 is disposed on the scale graduation element 2 in an arrangement substantially parallel to the incremental track 23, as shown in Figure 3. Said absolute track 21 comprises a pseudo-random sequence of marks 21a distributed pseudo-randomly in the direction of displacement X, and a periodic sequence of marks 21b distributed in said direction of displacement X with a specific absolute period P21b, greater than the incremental period P20 and a whole multiple of said incremental period P20. The marks 21a of the pseudo-random sequence are disposed between the marks 21b of the periodic sequence, only one mark 21a being disposed between every two marks 21b of the periodic sequence, separated from both marks 21b, or none, the presence and absence of said marks 21a of the pseudo-random sequence between every two marks 21b of the periodic sequence defining a pseudo-random code that is not repeated along the length of the scale graduation element 2, by means of which it is possible to determine the absolute position of the readhead 1. Figure 4 shows an embodiment of the pseudo-random and periodic sequences of the absolute track 21 on the scale graduation element 2, the marks 21a of the pseudo-random sequence being represented by a strip to make them easier to identify.

Thanks to the marks 21a of the pseudo-random sequence it is possible to identify the absolute position of the readhead 1 at all times, as the light that reaches the additional photodetector means 4 depends on the code represented by the marks 21a of the pseudo-random sequence which are passed through by or on which is reflected said light. As stated above, the marks 21a of the pseudo-random sequence are disposed between the marks 21b of the periodic sequence. In order to detect the absolute position, the code of the absolute track 21 is interpreted as a sequence of bits, each bit corresponding to an absolute period P21b. A bit may have a value equal to one when there is a mark 21a of the pseudo-random sequence between two marks 21b of the periodic sequence (an absolute period P21b), and equal to zero when there is no mark 21a of said pseudo-random sequence between two marks 21b of said periodic sequence (an absolute period P21b), or vice versa. The additional photodetector means 4 are adapted to receive the light corresponding to a limited number of bits, said number of bits corresponding to a code that is interpreted by the processing means by means of the corresponding additional electrical signal 5, in order to determine the absolute position of the readhead 1 at each moment. As the marks 21a of the pseudo-random sequence are disposed in pseudo-random arrangement, no code is repeated along the length of the scale graduation element 2, the absolute position of the readhead 1 thus being able to be determined at each moment.

The marks 21b of the periodic sequence do not define any code for the identification of the absolute position of the readhead 1, a function that is performed by the marks 21a of the pseudo-random sequence as stated above. Thanks to said marks 21b, the encoder 100 of the invention allows the additional electrical signal 5 to comprise a greater number of transitions (edges or changes of level) in each bit, regardless of the pseudo-random code used, as the marks 21a are also separated from said marks 21b when they are positioned between two of said marks 21b. As a result, if two marks 21a of said pseudo-random sequence are disposed in two adjacent spaces delimited by marks 21b of the periodic sequence, for example, there are a plurality of transitions in the additional electrical signal 5: two transitions due to the detection of the first mark 21b, another two transitions due to the first 21a (it must be remembered that there is a transparent area between both marks if said marks 21a and 21b are opaque, or opaque if said marks 21a and 21b are transparent), with the same occurring with the second marks 21a and 21b. In addition to marks and areas with transparency and opacity properties, they may also be marks and areas with reflective properties. As a result, there would thus be a reflective area between both marks if said marks 21a and 21b were non-reflective, or non-reflective if said marks 21a and 21b were reflective.

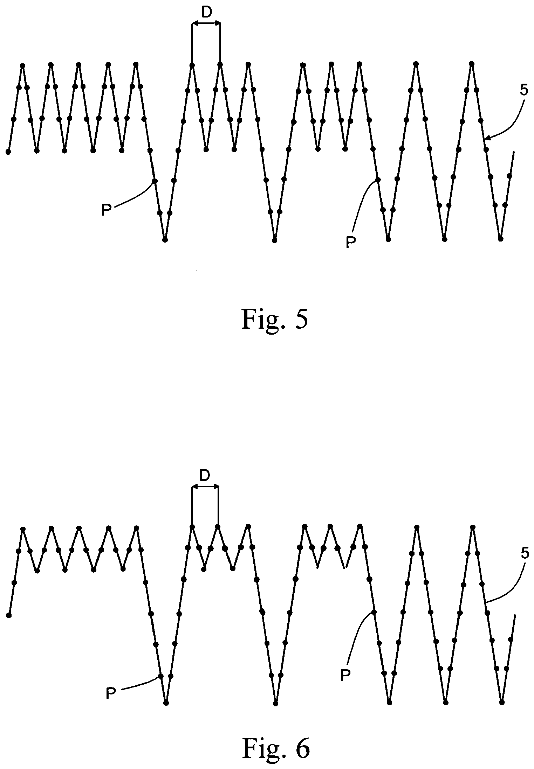

The calculation of the position of the encoder 100 involves points P of the transitions, shown in Figures 5 and 6, for example, the error in said calculation being smaller the greater the number of points P that are involved. For this reason, as with other factors, the greater the number of transitions and the greater the number of points P per transition the greater the resolution in the calculation of the position.

In the absolute track 21 of the encoder 100 of the invention, due to the presence of the transitions, if a small amount of dirt is deposited on said absolute track 21 for example, it may go unnoticed for the purposes of measuring the absolute position given that it would not affect the number of transitions, which would thus allow the presence or absence of the corresponding mark 21a to be determined. As a result, an encoder 100 that is more immune to the presence of dirt on the scale graduation element 2 or to the imperfections in the material used for the manufacture of said scale graduation element 2 is thus obtained, thereby providing a more robust absolute position encoder 100. In addition, in the event that the amount of dirt were sufficiently large to cause the elimination of some of the transitions, it would be possible to detect said elimination, and therefore said dirt, as no transition would be perceived in the corresponding additional electrical signal 5, which would be an indication of the presence of said dirt.

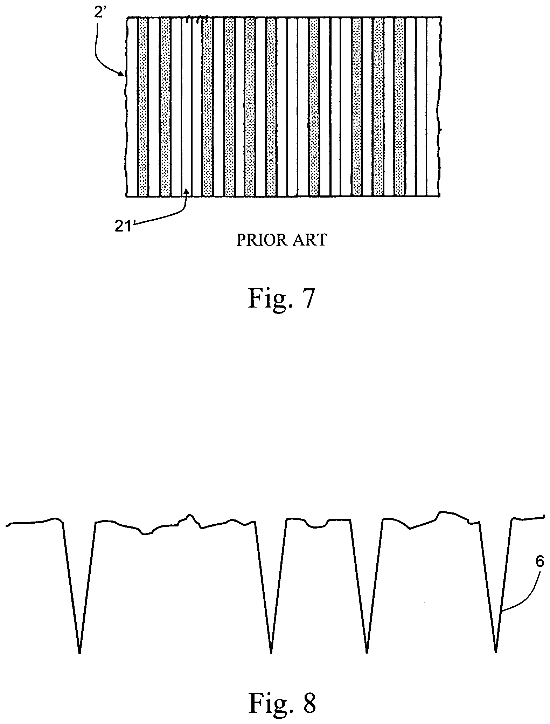

The form of the additional electrical signal 5 depends on the reading system used to capture said light, in other words, on the width of the emitter used and on the distances between said emitter and the scale graduation element, and between the analyser and said scale graduation element. In a preferred embodiment, the reading system used in the encoder 100 of the invention corresponds with the system described in patent application EP 1577646 A1. In said application a relationship is established between the width of the emitter, a first distance between said emitter and the scale graduation element and a second distance between the scale graduation element and the analyser. In the preferred embodiment, therefore, said relationship between the width of the emitter 10 and the distances between the emitter 10 and the scale graduation element 2 and between said scale graduation element and the analyser are achieved, with the specific characteristic that said first distance and said second distance are equal. An additional electrical signal 5 that presents at least one substantially triangular profile for each bit is thus obtained as a result, as shown in Figures 5 and 6, each bit comprising at least two transitions (two edges). As the first distance between said emitter 10 and the scale graduation element 2 and the second distance between the analyser and said scale graduation element 2 are equal, in addition in said preferred embodiment the same distance D between the "peaks" of the triangular profiles of the additional electrical signal 5 is obtained regardless of the value of said distances, as shown in said Figures 5 and 6. In contrast to what occurs with the absolute track 21 of the encoder 100 of the invention, with the absolute track 21' of the encoder of the document EP 5030716 A1 shown in Figure 7, for example, disposed on a scale graduation element 2' of said encoder, an additional electrical signal 6 such as the one shown in Figure 8 (using the reading system used in the preferred embodiment of the invention) is created. The pseudo-random code of Figure 7 does not correspond with the pseudo-random code of Figures 3 and 4, but based on the additional electrical signal 6 shown in Figure 8 it is evident that the resolution that may be obtained is smaller than with the encoder 100 of the invention due to the smaller number of transitions achieved. If dirt is deposited on said absolute track 21' or if the quality of the material used for the manufacture of the scale graduation element comprises imperfections, for example, the resulting additional electrical signal 6 may comprise an alteration that may be interpreted as a transition corresponding to a pseudo-random mark (or absence of one), giving rise to an incorrect absolute position measurement, something that would not occur with the encoder 100 of the invention.

With the absolute track 21 of the encoder 100 of the invention, by also using the reading system used in the preferred embodiment, greater resolution may be obtained in the measurement as due to the substantially triangular profile of the additional electrical signal 5 a greater number of points P of said additional electrical signal 5 may be identified during each of its transitions, as shown in Figures 5 and 6 for example, than if said transition or edge were formed abruptly, as a result of which a smaller number of points P of said additional electrical signal 5 could be detected during each of its transitions.

In the preferred embodiment the absolute period P21b is equal to twice the incremental period P20, thereby allowing better defined triangular profiles to be obtained, which in turn permits better resolutions. Figure 5 shows different points on each triangular profile which may correspond with different points to be taken into consideration for obtaining the absolute position and improving the resolution, instead of using only the points corresponding to the resolution of the bits that would form the peaks of each triangular profile. It is possible to use other absolute periods P21b such as one equal to three times the incremental period P20, but triangular profiles lose definition and although the resolution in relation to an absolute track that does not comprise the periodic sequence of marks 21b is improved, the risk of the resolution being reduced due to the use of a low-quality substratum of the scale graduation element 1, for example, is greater than when said absolute period P21b is equal to twice the incremental period P20. Figure 6 shows an additional electrical signal 5 that uses an absolute period P21b equal to three times the incremental period P20.

In the preferred embodiment the marks 21a and 21b of both sequences of the absolute track 21 also comprise a width equal to the periodic marks 20, which is equal to half the incremental period P20. In addition, in said preferred embodiment, the centre of the mark 21a coincides with the centre of a space delimited between the two marks 21b of the periodic sequence in which it is disposed, and the centre of each mark 21b coincides, in the direction of displacement X, with the centre of a corresponding periodic mark 20.

## Claims

1. Absolute position encoder, comprising
a scale graduation element (2) with an incremental track (23) and an absolute track (21), and
a readhead (1) that may be displaced in relation to the scale graduation element (2) in a direction of displacement (X) substantially parallel to said scale graduation element (2),
the incremental track (23) comprising a plurality of periodic marks (20) distributed with an incremental period (P20) in the direction of displacement (X), and the readhead (1) comprising
a light emitter (10) for lighting up the scale graduation element (2),
an analyser that receives part of the light that passes through or is reflected on said scale graduation element (2), and which generates electrical signals representative of said received light, and
processing means that receive said electrical signals and which determine the position of the readhead (1) in accordance with said electrical signals,
the analyser comprising photodetector means that generate two electrical signals in quadrature representative of the light that after passing through or being reflected on the periodic marks (20) reaches the analyser, said electrical signals in quadrature being used to determine an incremental position between the readhead (1) and said scale graduation element (2),
said analyser also comprising additional photodetector means (4) that generate at least one additional electrical signal (5) representative of the light that after passing through or being reflected on the absolute track (21) reaches the analyser and that correspond with a linear arrangement of photodetectors, said additional electrical signal (5) being used to determine the absolute position of the readhead (1), wherein the absolute track (21) comprises
a pseudo-random sequence of marks (21a), and a periodic sequence of marks (21b) distributed in the direction of displacement (X) with an absolute period (P21b) greater than the incremental period (P20) and a whole multiple of said incremental period (P20),
a maximum of one mark (21a) of the pseudo-random sequence being disposed between every two marks (21b) of the periodic sequence, separated from both marks (21b) of said periodic sequence, the presence or absence of said marks (21a) of the pseudo-random sequence in the direction of displacement (X) defining a pseudo-random code,
the code of the absolute track (21) being interpreted as a sequence of bits, each bit corresponding to an absolute period (P21b) and the additional photodetector means (4) being adapted to receive the light corresponding to a limited number of bits, said number of bits corresponding to a code that is interpreted by the processing means by means of the corresponding additional electrical signal (5) in order to determine the absolute position of the readhead (1),
the absolute track (21) enabling the additional electrical signal (5) representative of the light that passes through or is reflected on said absolute track (21) to comprise a greater number of transitions in each bit as a result of the separation of the marks (21a) of the pseudo-random sequence from the marks (21b) of the of the periodic sequence, where a transition is an edge or a change in level.

2. Absolute position encoder according to claim 1, wherein the absolute period (P21b) is equal to twice the incremental period (P20).

3. Absolute position encoder according to any of claims 1 or 2, wherein the centre of the mark (21a) of the pseudo-random sequence of the absolute track (21) coincides with the centre of a space delimited between the two marks (21b) of the periodic sequence between which is disposed said mark (21a) of the pseudo-random sequence.

4. Absolute position encoder according to any of claims 1 to 3, wherein the centre of each mark (21b) of the periodic sequence coincides, in the direction of displacement (X), with the centre of a corresponding periodic mark (20).

5. Absolute position encoder according to any of claims 1 to 4, wherein the marks (21a, 21b) of both sequences of the absolute track (21) and the periodic marks (20) of the incremental track (23) comprise a width equal to half an incremental period (P20).

6. Absolute position encoder according to any of claims 1 to 5, wherein the emitter (10) comprises a determined width, a first distance between said emitter (10) and the scale graduation element (2) and a second distance between the analyser and said scale graduation element (2) being equal.

## Patentansprüche

1. Absolutpositionsgeber, umfassend
ein Skalenteilungselement (2) mit einer Inkrementalspur (23) und einer Absolutspur (21), und
einen Lesekopf (1), welcher in Bezug auf das Skalenteilungselement (2) in einer Verschiebungsrichtung (X) im Wesentlichen parallel zum genannten Skalenteilungselement (2) verschoben werden kann,
wobei die Inkrementalspur (23) eine Vielzahl von periodischen Markierungen (20) umfasst, welche mit einer Inkrementalperiode (P20) in der Verschiebungsrichtung (X) verteilt sind, und wobei der Lesekopf (1) Folgendes umfasst
einen Lichtsender (10) zum Aufleuchten des Skalenteilungselementes (2),
einen Analysator, welcher einen Teil des Lichtes empfängt, welches durchgeht oder auf dem genannten Skalenteilungselement (2) reflektiert wird, und welcher elektrische Signale erzeugt, welche für das genannte empfangene Licht repräsentativ sind, und
Verarbeitungsmittel, welche die genannten elektrischen Signale empfangen und welche die Stellung des Lesekopfes (1) gemäß der genannten elektrischen Signale bestimmen,
wobei der Analysator Photodetektormittel umfasst, welche zwei elektrische Signale in Quadratur erzeugen, welche für das Licht repräsentativ sind, welches nachdem es durchgeht oder auf den periodischen Markierungen (20) reflektiert wird, den Analysator erreicht, wobei die genannten elektrischen Signale in Quadratur dazu verwendet werden, eine Inkrementalstellung zwischen dem Lesekopf (1) und dem genannten Skalenteilungselement (2) zu bestimmen,
wobei der genannte Analysator auch zusätzliche Photodetektormittel (4) umfasst, welche mindestens ein zusätzliches elektrisches Signal (5) erzeugen, welches für das Licht repräsentativ ist, welches nachdem es durchgeht oder auf der Absolutspur (21) reflektiert wird, den Analysator erreicht und welche einer linearen Anordnung von Photodetektoren entsprechen, wobei das genannte zusätzliche elektrische Signal (5) dazu verwendet wird, die Absolutstellung des Lesekopfes (1) zu bestimmen,
wobei
die Absolutspur (21) Folgendes umfasst
eine pseudozufällige Sequenz von Markierungen (21a), und eine periodische Sequenz von Markierungen (21b), welche in der Verschiebungsrichtung (X) mit einer Absolutperiode (P21b) größer als die Inkrementalperiode (P20) und einem ganzzahligen Mehrfache der genannten Inkrementalperiode (P20) verteilt sind,
wobei ein Maximalwert einer Markierung (21a) der pseudozufälligen Sequenz zwischen jede zwei Markierungen (21b) der periodischen Sequenz angeordnet wird, getrennt von beiden Markierungen (21b) der genannten periodischen Sequenz, wobei die Anwesenheit oder Abwesenheit der genannten Markierungen (21a) der pseudozufälligen Sequenz in der Verschiebungsrichtung (X) einen pseudozufälligen Code definiert,
wobei der Code der Absolutspur (21) als eine Bitfolge interpretiert wird, wobei jedes Bit einer Absolutperiode (P21b) entspricht und wobei die zusätzlichen Photodetektormittel (4) dazu angepasst sind, das Licht zu empfangen, welches einer beschränkten Anzahl von Bits entspricht, wobei die genannte Anzahl von Bits einem Code entspricht, welcher von den Verarbeitungsmitteln mittels des entsprechenden zusätzlichen elektrischen Signals (5) interpretiert wird, um die Absolutstellung des Lesekopfes (1) zu bestimmen,
wobei die Absolutspur (21) ermöglicht, dass das zusätzliche elektrische Signal (5), welches für das Licht repräsentativ ist, welches durchgeht oder auf der genannten Absolutspur (21) reflektiert wird, eine größere Anzahl von Übergängen in jedem Bit umfasst, als Ergebnis der Trennung der Markierungen (21a) der pseudozufälligen Sequenz von den Markierungen (21b) der periodischen Sequenz, wobei ein Übergang eine Grenze oder ein Höhenwechsel ist.

2. Absolutpositionsgeber nach Anspruch 1, wobei die Absolutperiode (P21b) gleich zweimal die Inkrementalperiode (P20) ist.

3. Absolutpositionsgeber nach einem der Ansprüche 1 oder 2, wobei der Mittelpunkt der Markierung (21a) der pseudozufälligen Sequenz der Absolutspur (21) mit dem Mittelpunkt eines Raumes übereinstimmt, welcher zwischen den zwei Markierungen (21b) der periodischen Sequenz beschränkt wird, zwischen welchen die genannte Markierung (21a) der pseudozufälligen Sequenz angeordnet ist.

4. Absolutpositionsgeber nach einem der Ansprüche 1 bis 3, wobei der Mittelpunkt jeder Markierung (21b) der periodischen Sequenz, in der Verschiebungsrichtung (X), mit dem Mittelpunkt einer entsprechenden periodischen Markierung (20) übereinstimmt.

5. Absolutpositionsgeber nach einem der Ansprüche 1 bis 4, wobei die Markierungen (21a, 21b) von beiden Sequenzen der Absolutspur (21) und der periodischen Markierungen (20) der Inkrementalspur (23) eine Breite gleich die Hälfte einer Inkrementalperiode (P20) umfassen.

6. Absolutpositionsgeber nach einem der Ansprüche 1 bis 5, wobei der Sender (10) eine bestimmte Breite umfasst, wobei ein erster Abstand zwischen dem genannten Sender (10) und dem Skalenteilungselement (2) und ein zweiter Abstand zwischen dem Analysator und dem genannten Skalenteilungselement (2) gleich sind.

## Revendications

1. Codeur de position absolue, comprenant :
un élément de graduation d'échelle (2) avec une piste incrémentale (23) et une piste absolue (21), et
une tête de lecture (1) qui peut être déplacée par rapport à l'élément de graduation d'échelle (2) dans une direction de déplacement (X) essentiellement parallèle audit élément de graduation d'échelle (2),
la piste incrémentale (23) comprenant une pluralité de marques périodiques (20) distribuées avec une période incrémentale (P20) dans la direction de déplacement (X) et la tête de lecture (1) comprenant
un émetteur de lumière (10) pour illuminer l'élément de graduation d'échelle (2),
un analyseur qui reçoit une partie de la lumière qui traverse ou est réfléchie sur ledit élément de graduation d'échelle (2) et qui génère des signaux électriques représentatifs de ladite lumière reçue, et
des moyens de traitement qui reçoivent lesdits signaux électriques et qui déterminent la position de la tête de lecture (1) selon lesdits signaux électriques,
l'analyseur comprenant des moyens photocapteurs qui génèrent deux signaux électriques en quadrature représentatifs de la lumière qui après avoir traversé ou avoir été réfléchie sur les marques périodiques (20) atteint l'analyseur, lesdits signaux électriques en quadrature étant utilisés pour déterminer une position incrémentale entre la tête de lecture (1) et ledit élément de graduation d'échelle (2),
ledit analyseur comprenant également des moyens photocapteurs supplémentaires (4) qui génèrent au moins un signal électrique supplémentaire (5) représentatif de la lumière qui après avoir traversé ou avoir été réfléchie sur la piste absolue (21) atteint l'analyseur et qui correspondent à un aménagement linéaire des photocapteurs, ledit signal électrique supplémentaire (5) étant utilisé pour déterminer la position absolue de la tête de lecture (1),
dans lequel
la piste absolue (21) comprend
une séquence pseudo-aléatoire de marques (21a), et une séquence périodique de marques (21b) distribuées dans la direction de déplacement (X) avec une période absolue (P21b) supérieure à la période incrémentale (P20) et un multiple entier de ladite période incrémentale (P20)
un maximum d'une marque (21a) de la séquence pseudo-aléatoire étant disposée entre toutes les deux marques (21b) de la séquence périodique, séparée des deux marques (21b) de ladite séquence périodique, la présence ou absence desdites marques (21a) de la séquence pseudo-aléatoire dans la direction de déplacement (X) définissant un code pseudo-aléatoire,
le code de la piste absolue (21) étant interprété comme une séquence de bits, chaque bit correspondant à une période absolue (P21b) et les moyens photocapteurs supplémentaires (4) étant adaptés pour recevoir la lumière correspondant à un nombre limité de bits, ledit nombre de bits correspondant à un code qui est interprété par les moyens de traitement par le biais du signal électrique supplémentaire correspondant (5) afin de déterminer la position absolue de la tête de lecture (1),
la piste absolue (21) permet que le signal électrique supplémentaire (5) représentatif de la lumière qui traverse ou est réfléchi sur ladite piste absolue (21) comprenne un nombre supérieur de transitions dans chaque bit du fait de la séparation des marques (21a) de la séquence pseudo-aléatoire des marques (21a) de la séquence périodique, où une transition est un bord ou un changement de niveau.

2. Codeur de position absolue selon la revendication 1, dans lequel la période absolue (P21b) est égale à deux fois la période incrémentale (P20).

3. Codeur de position absolue selon l'une quelconque des revendications 1 ou 2, dans lequel le centre de la marque (21A) de la séquence pseudo-aléatoire de la piste absolue (21) coïncide avec le centre d'un espace délimité entre les deux marques (21b) de la séquence périodique entre lesquelles est disposée ladite marque (21a) de la séquence pseudo-aléatoire.

4. Codeur de position absolue selon l'une quelconque des revendications 1 à 3, dans lequel le centre de chaque marque (21b) de la séquence périodique coïncide, dans la direction de déplacement (X), avec le centre d'une marque périodique correspondante (20).

5. Codeur de position absolue selon l'une quelconque des revendications 1 à 4, dans lequel les marques (21a, 21b) des deux séquences de la piste absolue (21) et les marques périodique (20) de la piste incrémentale (23) comprennent une largeur égale à la moitié d'une période incrémentale (P20).

6. Codeur de position absolue selon l'une quelconque des revendications 1 à 5, dans lequel l'émetteur (10) comprend une largeur déterminée, une première distance entre ledit émetteur (10) et l'élément de graduation d'échelle (2) et une seconde distance entre l'analyseur et ledit élément de graduation d'échelle (2) étant égales.
